# EUROPEAN PATENT APPLICATION

(11) **EP 3 826 052 A1**
(43) Date of publication of application: **26.05.2021**
(21) Application number: 19838049.5
(22) Date of filing: 04.07.2019
(51) Int. Cl.: H01L 23/36, H01L 23/373, H05K 7/20

(54) **HEAT-CONDUCTIVE SHEET, METHOD FOR MANUFACTURING SAME, AND METHOD FOR MOUNTING HEAT-CONDUCTIVE SHEET**

(30) Priority: 18.07.2018 JP 2018134769
(71) Applicant: Dexerials Corporation, Tokyo 141-0032 (JP)
(72) Inventor: TOBATA, Marina, Tokyo 141-0032 (JP); ARAMAKI, Keisuke, Tokyo 141-0032 (JP)
(74) Representative: Müller-Boré & Partner Patentanwälte PartG mbB
(86) International application number: PCT/JP2019/026749
(87) International publication number: WO 2020/017350

(57) **Abstract**

Provided are a thermally conductive sheet excellent in adhesiveness to an electronic component, handleability and reworkability, a method for manufacturing the same, and a method for mounting a thermally conductive sheet. The sheet includes: a sheet body 2 obtained by curing a binder resin containing at least a polymer matrix component and a fibrous thermally conductive filler 10, wherein the volume ratio of the fibrous thermally conductive filler 10 to the binder resin is 0.6 or less considering the binder resin as 1, and the fibrous thermally conductive filler 10 projects from the surface of the sheet body 2 and is coated with an uncured component of the binder resin.

## Description

### TECHNICAL FIELD

The present technology relates to a thermally conductive sheet which is pasted to an electronic component or the like to improve heat dissipation. This application claims priority on the basis of Japanese Patent Application No. 2018-134769 filed in Japan on July 18, 2018, and is incorporated herein by reference.

### BACKGROUND ART

Conventionally, in a semiconductor device mounted on various electrical devices such as a personal computer or other devices, various cooling means are used because heat is generated by driving the device, and when the generated heat is accumulated, the driving of the semiconductor device and peripheral devices are adversely affected. As a method of cooling an electronic component such as a semiconductor element, there are known a method of cooling air in a device housing by attaching a fan to the device and a method of attaching a heat sink such as a heat radiating fin or a heat radiating plate to the semiconductor element to be cooled, among other methods.

In the case of cooling a semiconductor element by attaching a heat sink to the semiconductor element, a thermally conductive sheet is provided between the semiconductor element and the heat sink in order to efficiently discharge the heat of the semiconductor element. As the thermally conductive sheet, a sheet in which a filler such as a thermally conductive filler such as carbon fiber is contained and dispersed in a silicone resin is widely used (see, Patent Document 1). The thermally conductive filler has anisotropic thermal conductivity, and it is known that, for example, when carbon fibers are used as the thermally conductive filler, the filler has a thermal conductivity of about 600 W/m^{∗}K to 1,200 W/m^{∗}K in the fiber direction, and when boron nitride is used, the filler has an anisotropic property with a thermal conductivity of about 110 W/m^{∗}K in the surface direction and a thermal conductivity of about 2 W/m^{∗}K in the direction perpendicular to the surface direction.

### PRIOR ART REFERENCE

### PATENT REFERENCE

Patent Document 1: Japanese Patent Application Publication No. 2012-023335
Patent Document 2: Japanese Patent Application Publication No. 2015-029076
Patent Document 3: Japanese Patent Application Publication No. 2015-029075

### SUMMARY OF THE INVENTION

### PROBLEM TO BE SOLVED BY THE INVENTION

Here, the amount of heat radiation of electronic components such as a CPU of a personal computer tends to increase year by year in accordance with the improvement in speed and performance thereof. On the other hand, the chip size of the processor or the like becomes equal to or smaller than the conventional size due to the advance of the fine silicon circuit technology, thereby increasing the heat flow rate per unit area. Therefore, it is required to dissipate heat and cool the electronic components such as the CPU more efficiently in order to avoid problems caused by the temperature rise.

In order to improve the heat radiation properties of the thermally conductive sheet, it is required to reduce the thermal resistance, which is an index indicating the difficulty of heat transfer. In order to reduce the thermal resistance, it is effective to improve the adhesiveness to a heat-generating element such as an electronic component or a heat-radiating element such as a heat sink or to reduce the thermal resistance by thinning the thermally conductive sheet.

When a thermally conductive molded body is thinly sliced to form a thermally conductive sheet, the surface of the sliced sheet has irregularities and poor adhesiveness with the electronic component. This poor adhesiveness causes problems such as falling from the component due to not adhering to the component in the mounting process; further, air is contained due to poor adhesiveness to a heat-generating element such as an electronic component or a heat-radiating element such as a heat sink so that thermal resistance cannot be sufficiently reduced.

In order to solve these problems, a technique has been proposed in which a surface of a thermally conductive sheet produced by slicing a thermally conductive molded body is pressed or left standing for a long time to exude an uncured component of the binder resin to the surface to improve the adhesiveness between the thermally conductive sheet and the electronic component (see, Patent Documents 2 and 3).

However, when the uncured component of the binder resin exudes onto the surface of the sheet, stickiness is imparted to the sheet, resulting in a problem of poor handling. Therefore, it is preferable to use a thermally conductive sheet having a tackiness (stickiness) at the time of mounting the electronic component, but reducing the tackiness before mounting.

Further, the thermally conductive sheet is required to have reworkability for correcting the positional deviation at the time of assembling the electronic component and the heat radiating member, or enabling the sheet to be disassembled for some reason and reassembled after being once assembled. That is, even after the load applied by being sandwiched between the electronic component and the heat radiating member is removed, it is preferable that the thermally conductive sheet exhibits tackiness in the same manner as before the application of the load and can be mounted on the electronic component, and maintains the same handleability and adhesiveness as before the application of the load.

Accordingly, it is an object of the present invention to provide a thermally conductive sheet having excellent adhesiveness to an electronic component, handleability, and reworkability, a method for manufacturing the same, and a method for mounting the thermally conductive sheet.

### MEANS OF SOLVING THE PROBLEM

In order to solve the problems described above, a thermally conductive sheet according to the present technology includes: a sheet body formed by curing a binder resin containing at least a polymer matrix component and a fibrous thermally conductive filler, wherein the volume ratio of the fibrous thermally conductive filler to the binder resin is 0.6 or less considering the binder resin as 1, and wherein the fibrous thermally conductive filler projects from the surface of the sheet body and is coated with an uncured component of the binder resin.

A method for manufacturing a thermally conductive sheet according to the present technology includes: a step of forming a thermally conductive molded body by molding and curing a thermally conductive resin composition containing a fibrous thermally conductive filler in a binder resin into a predetermined shape; and a step of slicing the thermally conductive molded body into a sheet shape to form a thermally conductive sheet, wherein the volume ratio of the fibrous thermally conductive filler to the binder resin is 0.6 or less considering the binder resin as 1, and wherein the fibrous thermally conductive filler projects from the surface of the sheet body and is coated with an uncured component of the binder resin.

A method for mounting a thermally conductive sheet according to the present technology is a method for mounting a thermally conductive sheet to be mounted on an electronic component and sandwiched between the electronic component and a heat dissipating member, including: a step of applying a load to the thermally conductive sheet to generate a tackiness when the thermally conductive sheet is mounted on the electronic component, thereby pasting the thermally conductive sheet to the electronic component, and when the thermally conductive sheet is repasted, the load is released, the thermally conductive sheet is separated from the electronic component, and the thermally conductive sheet is repasted onto the electronic component, wherein the thermally conductive sheet includes: a sheet body formed by curing a binder resin containing at least a polymer matrix component and a fibrous thermally conductive filler, wherein the volume ratio of the fibrous thermally conductive filler to the binder resin is 0.6 or less considering the binder resin as 1, and wherein the fibrous thermally conductive filler projects from the surface of the sheet body and is coated with an uncured component of the binder resin.

### EFFECTS OF THE INVENTION

According to the present technology, the tackiness is reduced or eliminated by projecting the fibrous thermally conductive filler on the sheet surface. When a load is applied to the sheet body in actual use, tackiness is exhibited. Therefore, the thermally conductive sheet has an excellent handleability and workability by reducing or eliminating the tackiness before mounting, and also exhibits the tackiness at the time of mounting, so that the thermal resistance can be reduced by improving the adhesiveness with the electronic component and the heat radiation member even when the sheet surface has irregularities.

Further, in the thermally conductive sheet, when the applied load is released, the sheet body is restored to a thickness of 90% or more. At this time, the tackiness is reduced or eliminated. Therefore, even when the thermally conductive sheet is remounted, the handleability and the adhesiveness are not different from the first mounting so that the reworkability is excellent.

### BRIEF DESCRIPTION OF THE DRAWINGS

FIG. 1 is a cross-sectional view of a thermally conductive sheet according to the present technology.
FIG. 2 is a perspective view illustrating an example of a step of slicing a thermally conductive molded body.
FIG. 3 is a cross-sectional view illustrating a step of pressing a thermally conductive sheet with a release film applied thereto.
FIG. 4 is a cross-sectional view showing an example of a semiconductor device.

### MODE FOR CARRYING OUT THE INVENTION

Hereinafter, a thermally conductive sheet according to the present technology, a method for manufacturing the same, and a method for mounting the thermally conductive sheet will be described in detail with reference to the drawings. It should be noted that the present disclosure is not limited to the following embodiments and various modifications can be made without departing from the scope of the present technology. Moreover, the features illustrated in the drawings are shown schematically and are not intended to be drawn to scale. Actual dimensions should be determined in consideration of the following description. Furthermore, those skilled in the art will appreciate that dimensional relations and proportions may be different among the drawings in certain parts.

The thermally conductive sheet according to the present technology includes a sheet body formed by curing a binder resin containing at least a polymer matrix component and a fibrous thermally conductive filler. In the thermally conductive sheet, the volume ratio of the fibrous thermally conductive filler to the binder resin is 0.6 or less considering the binder resin as 1. Further, the fibrous thermally conductive filler projects from the surface of the sheet body and is coated with an uncured component of the binder resin.

In such a thermally conductive sheet, the tackiness is reduced or eliminated by projecting the fibrous thermally conductive filler on the sheet surface. Further, when a load is applied to the sheet body by pressing in advance or by being sandwiched between an electronic component and a heat dissipating member in actual use, the fibrous thermally conductive filler projecting on the sheet surface is buried in the sheet body, and an uncured component of the binder resin carried in the sheet body exudes, thereby exhibiting tackiness. Therefore, the thermally conductive sheet has an excellent handleability and workability by reducing or eliminating the tackiness before mounting, and also exhibits the tackiness at the time of mounting, so that the adhesion with the electronic component and the heat radiation member can be improved and the thermal resistance can be reduced even when the sheet surface has irregularities.

Further, in the thermally conductive sheet, by setting the volume ratio of the fibrous thermally conductive filler to the binder resin is 0.6 or less considering the binder resin as 1, even when the load applied at the time of mounting to the electronic component or the like is released due to a reason such as correction of the positional deviation, the sheet body is recovered to a thickness of 90% or more. At this time, the fibrous thermally conductive filler buried in the sheet body projects again on the sheet surface, and the tackiness is reduced or eliminated. Therefore, even when the thermally conductive sheet is remounted, the handleability and the adhesiveness are not different from the first mounting so that the reworkability is excellent.

### Thermally conductive sheet

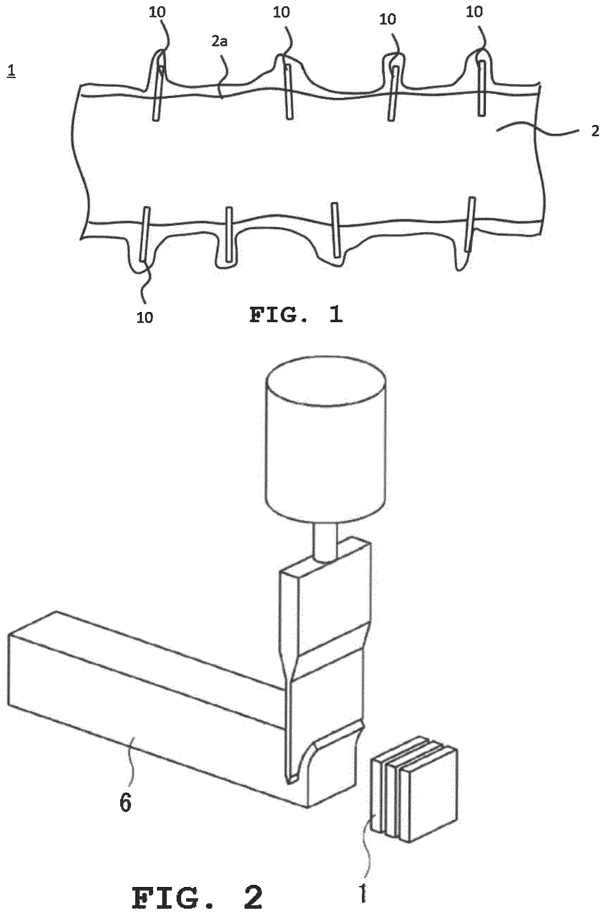

FIG. 1 shows a thermally conductive sheet 1 according to the present technology. The thermally conductive sheet 1 includes a sheet body 2 formed by curing a binder resin containing at least a polymer matrix component and a fibrous thermally conductive filler.

On the surface 2a of the sheet body 2, a fibrous thermally conductive filler 10 described later projects. Thus, the tackiness of the thermally conductive sheet 1 is reduced or eliminated. Here, the reduction or elimination of the tackiness means that the tackiness is reduced to such a degree that the tackiness is not felt when a person touches the sheet, thereby improving the handleability and workability of the thermally conductive sheet 1. It should be noted that, in the thermally conductive sheet 1, although some amount of an uncured component 11 of the binder resin exudes from the sheet body 2 to cover the thermally conductive filler 10 projecting from the surface, as will be described later in detail, the thermally conductive filler 10 reduces or eliminates the tackiness by projecting from the sheet surface by a predetermined length or more.

### Polymer matrix component

The polymer matrix component constituting the sheet body 2 is a polymer component serving as a base material of the thermally conductive sheet 1. The type is not particularly limited, and a known polymer matrix component can be appropriately selected. For example, one of the polymer matrix components is a thermosetting polymer.

Examples of the thermosetting polymer include crosslinked rubber, epoxy resin, polyimide resin, bismaleimide resin, benzocyclobutene resin, phenol resin, unsaturated polyester, diallyl phthalate resin, silicone resin, polyurethane, polyimide silicone, thermosetting polyphenylene ether, and thermosetting modified polyphenylene ether, among others. These may be used alone or in combination of two or more.

Examples of the crosslinked rubber include natural rubber, butadiene rubber, isoprene rubber, nitrile rubber, hydrogenated nitrile rubber, chloroprene rubber, ethylene propylene rubber, chlorinated polyethylene, chlorosulfonated polyethylene, butyl rubber, halogenated butyl rubber, fluorine rubber, urethane rubber, acrylic rubber, polyisobutylene rubber, and silicone rubber, among others. These may be used alone or in combination of two or more.

Among these thermosetting polymers, it is preferable to use a silicone resin in view of excellent moldability and weather resistance, as well as adhesiveness and followability to electronic components. The silicone resin is not particularly limited, and the kind of the silicone resin can be appropriately selected according to the purpose.

From the viewpoint of obtaining the molding processability, weather resistance, and adhesiveness, among others, the silicone resin is preferably a silicone resin composed of a main agent of a liquid silicone gel and a curing agent. Examples of such silicone resins include an addition reaction type liquid silicone resin and a heat vulcanization type millable type silicone resin using a peroxide for vulcanization. Among these, an addition reaction type liquid silicone resin is particularly preferable since adhesion between the heat generating surface of the electronic component and the heat sink surface is required as the heat radiating member for the electronic device.

As the addition reaction type liquid silicone resin, it is preferable to use a two-component addition reaction-type silicone resin or the like using a polyorganosiloxane having a vinyl group as a main agent and a polyorganosiloxane having a Si-H group as a curing agent.

The liquid silicone component includes a silicone A liquid component as a main agent and a silicone B liquid component containing a curing agent, and as the blending ratio of the silicone A liquid component and the silicone B liquid component, the amount of the silicone A liquid component is preferably more than the amount of the silicone B liquid component. Thus, the thermally conductive sheet 1 can impart flexibility to the sheet body 2, and exude an uncured component of the binder resin (polymer matrix component) onto the surfaces 2a, 2b of the sheet body 2 by a pressing step to exhibit tackiness.

Further, the content of the polymer matrix component in the thermally conductive sheet of the present technology is set such that the volume ratio of the fibrous thermally conductive filler to the binder resin is 0.6 or less considering the binder resin as 1, so that the recovery ratio after removal of the applied load can be 90% or more as described later, and reworkability can be provided.

### Fibrous thermally conductive filler

The fibrous thermally conductive filler contained in the thermally conductive sheet 1 is a component for improving the thermal conductivity of the sheet. Although the type of the thermally conductive filler is not particularly limited as long as it is a fibrous material having high thermal conductivity, it is preferable to use a carbon fiber in view of obtaining higher thermal conductivity.

The thermally conductive filler may be either one or a mixture of two or more. When two or more kinds of thermally conductive fillers are used, either of them may be a fibrous thermally conductive filler, or a fibrous thermally conductive filler and a thermally conductive filler of another shape may be mixed.

The type of the carbon fiber is not particularly limited and can be appropriately selected according to the purpose. For example, a pitch fiber, a PAN fiber, a graphitized PBO fiber, a composite made by an arc discharge method, a laser evaporation method, a CVD (chemical vapor deposition) method, a CCVD (catalytic chemical vapor deposition) method or the like can be used. Among these, carbon fibers obtained by graphitizing PBO fibers and pitch type carbon fibers are more preferable in view of obtaining high thermal conductivity.

The carbon fiber can be used by subjecting a part or the whole of the carbon fiber to surface treatment, as necessary. Examples of the surface treatment include an oxidation treatment, a nitriding treatment, a nitration, a sulfonation, or a treatment in which a metal, a metal compound, an organic compound, or the like is adhered or bonded to a functional group introduced to the surface by these treatments or to the surface of carbon fiber. Examples of the functional group include a hydroxyl group, a carboxyl group, a carbonyl group, a nitro group, and an amino group.

Further, although the average fiber length (average long axis length) of the carbon fibers is not particularly limited and can be selected as appropriate, from the viewpoint of reliably obtaining high thermal conductivity, it is preferably in the range of 50 to 300 µm, more preferably in the range of 75 to 275 µm, and particularly preferably in the range of 90 to 250 µm.

Further, although the average fiber diameter (average short axis length) of the carbon fiber is not particularly limited and can be appropriately selected, from the viewpoint of reliably obtaining high thermal conductivity, it is preferably in the range of 4 to 20 µm, and more preferably in the range of 5 to 14 µm.

The aspect ratio (average long axis length / average short axis length) of the carbon fiber is preferably 8 or more, more preferably 9 to 30, in view of ensuring high thermal conductivity. If the aspect ratio is less than 8, there is a risk that the thermal conductivity will decrease because the fiber length (long axis length) of the carbon fiber is short, while if the aspect ratio exceeds 30, there is a risk that sufficient thermal conductivity will not be obtained because the dispersibility in the thermally conductive sheet will decrease.

The average long axis length and the average short axis length of the carbon fibers can be measured by a microscope, a scanning electron microscope (SEM), or the like, for example, and an average can be calculated from a plurality of samples.

In addition, although the content of the fibrous thermally conductive filler in the thermally conductive sheet 1 is not particularly limited as long as the volume ratio of the fibrous thermally conductive filler to the polymer matrix component is 0.6 or less, and can be appropriately selected according to the purpose, it is preferably 4 to 40% by volume, and more preferably 5 to 35% by volume. If the content is less than 4% by volume, it may be difficult to obtain a sufficiently low thermal resistance, and if it is more than 40% by volume, it may affect the moldability of the thermally conductive sheet 1 and the orientation of the fibrous thermally conductive filler. The content of the thermally conductive filler containing the fibrous thermally conductive filler in the thermally conductive sheet 1 is preferably 15 to 75% by volume.

### Sheet surface projection/silicone coating

The fibrous thermally conductive filler projects from the surface of the sheet body 2 and is coated with the uncured component of the binder resin. The projection length of the fibrous thermally conductive filler from the surface of the sheet body 2 is preferably longer than 50 µm. Thus, the tackiness is reduced or eliminated before mounting the thermally conductive sheet 1, and workability and handleability can be improved.

In the thermally conductive sheet 1, since the fibrous thermally conductive filler is coated with the uncured component, contact thermal resistance can be reduced when the sheet 1 is mounted on an electronic component or the like. In the thermally conductive sheet 1, although the uncured binder resin component is present on the surface 2a of the sheet body 2, the fibrous thermally conductive filler projects, so that the worker does not feel any tack when touching the sheet but can perform a work such as positioning or the like with a tackiness when the sheet is mounted on an electronic component.

It should be noted that the projection length of the fibrous thermally conductive filler projecting from the surface of the sheet body 2 is the length from the base to the tip of the fibrous thermally conductive filler projecting from the surface of the sheet body 2. Further, although the tackiness of the thermally conductive sheet 1 can be reduced or eliminated by projecting all the fibrous thermally conductive filler by 50 µm or more from the surface of the sheet body 2, the length may be appropriately adjusted by a process of slicing into a sheet shape described later in accordance with the amount of the fibrous thermally conductive filler projecting from the surface 2a of the sheet body 2.

### Inorganic filler

The thermally conductive sheet 1 may further contain an inorganic filler as a thermally conductive filler. By containing the inorganic filler, the thermal conductivity of the thermally conductive sheet 1 is further enhanced and the strength of the sheet can be improved. The inorganic filler is not particularly limited in shape, material, average particle diameter and the like, and can be appropriately selected according to the purpose. Examples of the shape include a spherical shape, an elliptical spherical shape, a massive shape, a granular shape, a flat shape, and a needle-like shape. Among these, the spherical shape and the elliptical shape are preferable from the viewpoint of filling property, and the spherical shape is particularly preferable.

Examples of the material of the inorganic filler include aluminum nitride (Aluminum Nitride: A1N), silica, alumina (aluminum oxide), boron nitride, titania, glass, zinc oxide, silicon carbide, silicon, silicon oxide, and metal particles, among others. These may be used alone or in combination of two or more. Among these, alumina, boron nitride, aluminum nitride, zinc oxide, and silica are preferable, and alumina and aluminum nitride are particularly preferable from the viewpoint of thermal conductivity.

The inorganic filler may be surface treated. When the inorganic filler is treated with a coupling agent as the surface treatment, the dispersibility of the inorganic filler is improved and the flexibility of the thermally conductive sheet is improved.

The average particle diameter of the inorganic filler can be appropriately selected according to the kind of the inorganic substance or the like. When the inorganic filler is alumina, the average particle diameter thereof is preferably 1 to 10 µm, more preferably 1 to 5 µm, and particularly preferably 4 to 5 µm. When the average particle diameter is less than 1 µm, the viscosity increases and mixing may become difficult. On the other hand, when the average particle diameter exceeds 10 µm, there is a possibility that the thermal resistance of the thermally conductive sheet 1 increases.

Further, when the inorganic filler is aluminum nitride, the average particle diameter thereof is preferably 0.3 to 6.0 µm, more preferably 0.3 to 2.0 µm, and particularly preferably 0.5 to 1.5 µm. If the average particle diameter is less than 0.3 µm, the viscosity may increase and mixing may become difficult, and if the average particle diameter exceeds 6.0 µm, the thermal resistance of the thermally conductive sheet 1 may increase.

The average particle diameter of the inorganic filler can be measured, for example, by a particle diameter distribution meter or a scanning electron microscope (SEM).

### Other components

In addition to the above-mentioned polymer matrix components, fibrous thermally conductive filler, and appropriately contained inorganic filler, the thermally conductive sheet 1 may optionally contain other components depending on the purpose. Other components include, for example, magnetic metal powders, thixotropy imparting agents, dispersants, curing accelerators, retarders, fine tackifiers, plasticizers, flame retardants, antioxidants, stabilizers, and colorants, among others. The electromagnetic wave absorbing performance may be imparted to the thermally conductive sheet 1 by adjusting the content of the magnetic metal powder.

### Method for manufacturing thermally conductive sheet

Next, manufacturing steps of the thermally conductive sheet 1 will be described. The manufacturing steps of the thermally conductive sheet 1 according to the present technology includes: a step of forming a thermally conductive molded body by molding a thermally conductive resin composition containing a fibrous thermally conductive filler in a binder resin into a predetermined shape and curing the composition (Step A); a step of slicing the thermally conductive molded body into a sheet shape to form a thermally conductive sheet (Step B); and an optional step of exuding an uncured component of the binder resin by pressing the thermally conductive sheet (Step C).

### Step A

In this Step A, the above-mentioned polymer matrix component, the fibrous thermally conductive filler, the optional inorganic filler, and other components are blended to prepare a thermally conductive resin composition. As described above, in the method for manufacturing the thermally conductive sheet according to the present technology, the volume ratio of the fibrous thermally conductive filler to the binder resin is 0.6 or less considering the binder resin as 1. The procedure for preparing and blending each component is not particularly limited, and for example, a thermally conductive resin composition may be prepared by suitably adding and mixing a fibrous thermally conductive filler, an inorganic filler, magnetic metal powder, and other components to a polymer matrix component.

Next, the fibrous thermally conductive filler such as carbon fiber is oriented in one direction. The method of orienting the filler is not particularly limited as long as it can orient the filler in one direction. For example, by extruding or pressing the thermally conductive resin composition into a hollow mold under a high shearing force, the fibrous thermally conductive filler can be relatively easily oriented in one direction, and each member of the fibrous thermally conductive filler can be oriented in the same direction (within ± 10 °).

As the method for extruding or pressing the thermally conductive resin composition into the hollow mold under a high shearing force, an extrusion molding method or a metallic-mold molding method can be specifically mentioned. When the thermally conductive resin composition is extruded from a die in the extrusion molding method or when the thermally conductive resin composition is pressed into a mold in the metallic-mold molding method, the thermally conductive resin composition flows and the fibrous thermally conductive filler is oriented along the flow direction. At this time, by attaching a slit to the tip of the die, the fibrous thermally conductive filler can be more easily oriented.

The thermally conductive resin composition extruded or pressed into a hollow mold is molded into a block shape corresponding to the shape and size of the mold, and cured by curing the polymer matrix component while maintaining the orientation state of the fibrous thermally conductive filler, thereby forming a thermally conductive molded body. The thermally conductive molded body is a base material (molded body) for cutting out the thermally conductive sheet 1 obtained by cutting into a predetermined size.

The size and shape of the hollow mold and the thermally conductive molded body can be determined in accordance with the size and shape of the thermally conductive sheet 1 required and may be, for example, a rectangular parallelepiped with a cross-section having a longitudinal size of 0.5 to 15 cm and a lateral size of 0.5 to 15 cm. The length of the rectangular parallelepiped may be determined, as necessary.

The method and conditions for curing the polymer matrix component can be selected according to the type of the polymer matrix component. For example, when the polymer matrix component is a thermosetting resin, the curing temperature in thermosetting can be adjusted. Further, when the thermosetting resin contains a main agent of the liquid silicone gel and a curing agent, it is preferable to perform curing at a curing temperature of 80 to 120 °C. The curing time for thermosetting is not particularly limited, but may be from 1 to 10 hours.

In Step A, the whole amount of the polymer matrix component is not cured, but an uncured component is remained. The uncured component exudes on the surface of the sheet by pressing the thermally conductive sheet, and tackiness can be imparted to the surface of the sheet.

### [Step B]

As shown in FIG. 2, in the Step B of slicing a thermally conductive molded body 6 into a sheet shape and forming the thermally conductive sheet 1, the thermally conductive molded body 6 is cut into a sheet shape at an angle of 0° to 90° with respect to the longitudinal direction of the oriented fibrous thermally conductive filler. Thus, the thermally conductive filler 10 is oriented in the thickness direction of the sheet body.

The cutting of the thermally conductive molded body 6 is performed by using a slicing device. The type of the slicing device is not particularly limited as long as it can cut the thermally conductive molded body 6, and a known slicing device can be suitably used. For example, an ultrasonic cutter or a plane, among others, can be used.

The slice thickness of the thermally conductive molded body 6 is the thickness of the sheet body 2 of the thermally conductive sheet 1, and can be appropriately set according to the application of the thermally conductive sheet 1, for example, 0.5 to 3.0 mm.

In Step B, the thermally conductive sheet 1 may be formed into a plurality of small pieces of the thermally conductive sheet 1 by notching the thermally conductive sheet 1 cut out from the thermally conductive molded body 6.

In the thermally conductive sheet 1 manufactured through the above steps, the fibrous thermally conductive filler projects from the surface of the sheet body 2 that is a slice surface, thereby reducing or eliminating the tackiness. Thus, the thermally conductive sheet 1 has improved handleability and workability.

### [Step C]

The manufacturing steps of the thermally conductive sheet 1 may include a Step C of pressing the thermally conductive sheet 1 to exude an uncured component of the binder resin, as necessary. Thus, the entire of both surfaces of the thermally conductive sheet 1 are coated with the uncured component of the binder resin exuded from the sheet body 2, and the tackiness can be exhibited.

The pressing can be performed by using, for example, a pressing device including a pair of a flat plate and a press head with a flat surface. A pinch roll may also be used for pressing.

Although the pressure of the pressing is not particularly limited and can be appropriately selected according to the purpose, the pressure is preferably in the range of 0.1 to 100 MPa, and more preferably in the range of 0.5 to 95 MPa. since the thermal resistance tends to remain the same when the pressure is too low as when the press is not performed and the sheet tends to stretch when the pressure is too high.

Here, as described above, the entire amount of the polymer matrix component is not cured in the thermally conductive molded body, the uncured component of the binder resin (polymer matrix component) is carried on the sheet body in the molded body sheet, and a part of the uncured component is efficiently exuded on the sheet surface by the pressing step. Thus, the thermally conductive sheet 1 has tackiness on the sheet surface.

In addition, through the pressing step, the surface 2a of the thermally conductive sheet 1 carries an uncured component of a binder resin, which also improves the adhesion of the thermally conductive sheet 1 and reduces the interfacial contact resistance when a light load is applied.

As described above, according to the present technology, even from a sheet body which is thinly cut out and does not contain large amount of the uncured component of the binder resin, the uncured component can be exuded and the entire surface of the sheet can be coated with the uncured component. Further, even from a sheet body in which the curing of the binder resin is advanced so that the binder resin is relatively hard and excellent in shape maintainability and does not contain a large amount of the uncured component of the binder resin, the uncured component can be exuded and the entire surface of the sheet can be coated with the uncured component.

Therefore, according to the thermally conductive sheet manufactured by the present technology, the adhesion to the electronic component and the heat radiating member can be improved and the thermal resistance can be reduced regardless of the unevenness of the sheet surface. In addition, according to the thermally conductive sheet manufactured by the present technology, there is no need to apply an adhesive to the surface of the sheet to adhere to the electronic component and the heat dissipating member, and the thermal resistance of the sheet does not increase. Further, in a thermally conductive sheet in which a thermally conductive filler is contained in a binder resin, not only thermal resistance in a low load region can be reduced, but also tack force (adhesive force) is excellent, and mountability and thermal characteristics can be improved.

### Release film

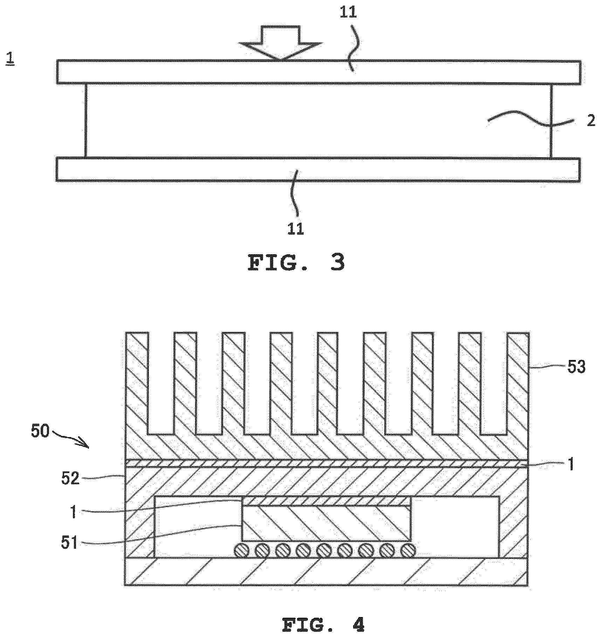

In the above-described Step C, as shown in FIG. 3, it is preferable to press the thermally conductive sheet 1 in a state where a plastic film 11 is pasted on at least one side, preferably both sides of the thermally conductive sheet 1. As the plastic film, for example, a PET film may be used. In addition, the plastic film may be subjected to a release treatment on the surface to be pasted to the molded body sheet.

By pasting the plastic film 11 on the surface of the sheet body 2 of the thermally conductive sheet 1, the uncured component exuded on the sheet surface in the pressing step is held on the sheet surface by the tension working with the plastic film 11 to form a resin coating layer covering the entire sheet surface.

In actual use, by releasing the plastic film, the surface of the thermally conductive sheet 1 having tackiness is exposed and mounted on an electronic component or the like.

### Example of usage

In actual use, the plastic film 11 is appropriately released from the thermally conductive sheet 1, and the thermally conductive sheet 1 is mounted inside, for example, an electronic component such as a semiconductor device or various electronic devices. At this time, since the thermally conductive sheet 1 has a reduced or eliminated tackiness on the surface of the sheet body 2 or a plastic film 11 is pasted thereto, it is excellent in handleability, and when a load is applied by being pressed against an electronic component or the like, the tackiness appears to improve workability.

As shown in FIG. 4, for example, the thermally conductive sheet 1 is mounted on a semiconductor device 50 to be incorporated in various electronic devices, and is sandwiched between a heat source and a heat radiating member. The semiconductor device 50 shown in FIG. 4 has at least an electronic component 51, a heat spreader 52, and a thermally conductive sheet 1, and the thermally conductive sheet 1 is sandwiched between the heat spreader 52 and the electronic component 51. By using the thermally conductive sheet 1, the semiconductor device 50 has a high heat radiation property and is excellent in electromagnetic wave suppression effect according to the content of the magnetic metal powder in the binder resin.

The electronic component 51 is not particularly limited and can be appropriately selected according to the purpose, and examples thereof include various semiconductor elements such as a CPU, an MPU, a graphic computing element, an image sensor, an antenna element, and a battery, among other components. The heat spreader 52 is not particularly limited as long as it is a member that radiates the heat generated by the electronic component 51 and can be appropriately selected according to the purpose. The thermally conductive sheet 1 is sandwiched between the heat spreader 52 and the electronic component 51. The thermally conductive sheet 1 constitutes a heat radiating member for radiating the heat of the electronic component 51 together with the heat spreader 52 by being sandwiched between the heat spreader 52 and a heat sink 53.

The mounting position of the thermally conductive sheet 1 is not limited to between the heat spreader 52 and the electronic component 51 or between the heat spreader 52 and the heat sink 53, and it is needless to say that the mounting position can be appropriately selected according to the configuration of the electronic device or the semiconductor device. Besides the heat spreader 52 and the heat sink 53, the heat radiating member may be a heat radiator, a cooler, a die pad, a printed circuit board, a cooling fan, a Peltier element, a heat pipe, a metal cover, and a housing, among others, as long as the heat radiating member conducts heat generated from the heat source and radiates the heat to the outside.

### Workability and reworkability

Further, the thermally conductive sheet 1 can be subjected to a rework operation in which the thermally conductive sheet is repasted such as when a positional deviation is corrected, or an assembly is once assembled, disassembled for some reason, and reassembled. At this time, when mounted to the electronic component or the like, the thermally conductive sheet 1 exhibits tackiness by applying a load and is pasted to the electronic component, and when repasting is required, the load is released, and the thermally conductive sheet 1 is peeled from the electronic component or the like and is pasted again to the electronic component or the like.

Here, in the thermally conductive sheet 1 according to the present technology, as described above, the volume ratio of the fibrous thermally conductive filler to the binder resin is 0.6 or less considering the binder resin as 1. In addition, the fibrous thermally conductive filler projects from the surface of the sheet body 2 and is coated with an uncured component of a binder resin.

In such a thermally conductive sheet 1, by setting the volume ratio of the fibrous thermally conductive filler to the binder resin is 0.6 or less considering the binder resin as 1, even when the load applied at the time of mounting to the electronic component or the like is released, the sheet body 2 is restored to a thickness of 90% or more.

Further, the thermally conductive sheet 1 having a small volume ratio of the fibrous thermally conductive filler to the binder resin of 0.6 or less has an appropriate flexibility, and has a low surface roughness on a slice surface when the thermally conductive molded body is sliced into a sheet shape, and for example, the maximum height Rz value thereof is lower than that of a thermally conductive sheet having a volume ratio larger than 0.6. In addition, the Rz value further decreases after the application of the load, and the difference between the Rz values before and after the application of the load is larger than that of a thermally conductive sheet having a volume ratio larger than 0.6.

In the thermally conductive sheet 1 having such a low Rz value after release of the applied load and a recovery rate of 90% or more in thickness after release of the applied load, the projection length of the fibrous thermally conductive filler from the sheet surface after release of the applied load is the same as at the beginning.

That is, the thermally conductive sheet 1 is once peeled off from the electronic component or the like, and the fibrous thermally conductive filler again projects on the sheet surface, thereby reducing or eliminating the tackiness. When a load is applied to the sheet body 2 at the time of repasting, such as by pressing in advance or by being sandwiched between the electronic component and the heat dissipating member, the fibrous thermally conductive filler projecting on the sheet surface is buried in the sheet body 2, and the uncured component of the binder resin carried in the sheet body 2 is exuded, thereby exhibiting tackiness again.

Therefore, during the rework operation, the thermally conductive sheet has an excellent handleability and workability by reducing or eliminating the tackiness before mounting, and also exhibits the tackiness at the time of mounting, so that the thermal resistance can be reduced by improving the adhesion with the electronic component and the heat radiating member even when the sheet surface has irregularities.

It should be noted that such a thermally conductive sheet 1 has the same effect and good workability not only during the rework operation but also when a press step is provided in advance before the first mounting operation.

### Examples

Next, examples of the present technology will be described. In these examples, a silicone composition (thermally conductive resin composition) containing carbon fibers as the fibrous thermally conductive filler and alumina was prepared, and a silicone cured product (thermally conductive molded body) was molded and sliced into a sheet to obtain a thermally conductive sheet. The resulting thermally conductive sheet was pressed, and the sheet thickness before and after pressing, the thermal resistance of the samples before and after pressing with a load of 0.8 kgf/cm² in accordance with ASTM-D 5470, the type OO hardness in accordance with Durometer hardness standard ASTM-D 2240 before and after pressing, the distance of carbon fibers from the surface of the thermally conductive sheet before and after pressing, and the surface roughness (Rz value) of the thermally conductive sheet before and after pressing were evaluated. The distance of the carbon fibers from the surface of the thermally conductive sheet before and after pressing was measured by a stereoscopic microscope with a magnification of 1,000 times (KEYENCE VHX-5000) as 3D (depth direction).

### Example 1

In Example 1, as shown in Table 1, a silicone composition was prepared by mixing two-component addition reaction-type liquid silicone with 46.2 % by volume of mixed alumina particles having average particle diameters of 1 µm and 5 µm which were subjected to coupling treatment with a silane coupling agent and 14 % by volume of pitch-based carbon fibers having an average fiber length of 200 µm. As the two-component addition reaction-type liquid silicone resin, a two-component addition reaction-type liquid silicone resin mainly composed of an organopolysiloxane was used and the blending ratio of the silicone A agent to the silicone B agent was 53:47. In Example 1, the total amount of the binder resin is 39.8% by volume, the blending amount of the carbon fiber is 14% by volume, and the volume ratio of the carbon fiber to the binder resin is 0.35.

The obtained silicone composition was extruded into a hollow quadrangular prism-shaped mold (50 mm x 50 mm) to form a silicone molded body with a cross-section of 50 mm square. The silicone molded body was heated in an oven at 100 °C for 6 hours to obtain a silicone cured product. The silicone cured product was cut with a slicer so as to have a thickness of 1.0 mm to obtain a thermally conductive sheet. Then, the thermally conductive sheet was sandwiched between release-treated PET films and the thermally conductive sheet was pressed at 87 °C and 0.5 MPa for 3 minutes.

### Example 2

In Example 2, the silicone cured product prepared in Example 1 was cut with a slicer so as to have a thickness of 2.0 mm to obtain a thermally conductive sheet. Then, the thermally conductive sheet was sandwiched between release-treated PET films and the thermally conductive sheet was pressed at 87 °C and 0.5 MPa for 3 minutes. In Example 2, the total amount of the binder resin is 39.8% by volume, the blending amount of the carbon fiber is 14% by volume, and the volume ratio of the carbon fiber to the binder resin is 0.35.

### Example 3

In Example 3, the silicone cured product prepared in Example 1 was cut with a slicer so as to have a thickness of 3.0 mm to obtain a thermally conductive sheet. Then, the thermally conductive sheet was sandwiched between release-treated PET films and the thermally conductive sheet was pressed at 87 °C and 0.5 MPa for 3 minutes. In Example 3, the total amount of the binder resin is 39.8% by volume, the blending amount of the carbon fiber is 14% by volume, and the volume ratio of the carbon fiber to the binder resin is 0.35.

### Example 4

In Example 4, as shown in Table 1, a silicone composition was prepared by mixing two-component addition reaction-type liquid silicone with 46.2% by volume of mixed alumina particles having average particle diameters of 1 µm and 5 µm which were subjected to coupling treatment with a silane coupling agent and 14% by volume of pitch-based carbon fibers having an average fiber length of 200 µm. As the two-component addition reaction-type liquid silicone resin, a two-component addition reaction-type liquid silicone resin mainly composed of an organopolysiloxane was used and the blending ratio of the silicone A agent to the silicone B agent was 58:42. In Example 4, the total amount of the binder resin is 39.8% by volume, the blending amount of the carbon fiber is 14% by volume, and the volume ratio of the carbon fiber to the binder resin is 0.35.

The obtained silicone composition was extruded into a hollow quadrangular prism-shaped mold (50 mm x 50 mm) to form a silicone molded body with a cross-section of 50 mm square. The silicone molded body was heated in an oven at 100 °C for 6 hours to obtain a silicone cured product. The silicone cured product was cut with a slicer so as to have a thickness of 3.0 mm to obtain a thermally conductive sheet. Then, the thermally conductive sheet was sandwiched between release-treated PET films and the thermally conductive sheet was pressed at 87 °C and 0.5 MPa for 3 minutes.

### Example 5

In Example 5, as shown in Table 1, a silicone composition was prepared by mixing two-component addition reaction-type liquid silicone with 46.2 % by volume of mixed alumina particles having average particle diameters of 1 µm and 5 µm which were subjected to coupling treatment with a silane coupling agent and 14 % by volume of pitch-based carbon fibers having an average fiber length of 200 µm. As the two-component addition reaction-type liquid silicone resin, a two-component addition reaction-type liquid silicone resin mainly composed of an organopolysiloxane was used and the blending ratio of the silicone A agent to the silicone B agent was 50:50. In Example 5, the total amount of the binder resin is 39.8% by volume, the blending amount of the carbon fiber is 14% by volume, and the volume ratio of the carbon fiber to the binder resin is 0.35.

The obtained silicone composition was extruded into a hollow quadrangular prism-shaped mold (50 mm x 50 mm) to form a silicone molded body with a cross-section of 50 mm square. The silicone molded body was heated in an oven at 100 °C for 6 hours to obtain a silicone cured product. The silicone cured product was cut with a slicer so as to have a thickness of 3.0 mm to obtain a thermally conductive sheet. Then, the thermally conductive sheet was sandwiched between release-treated PET films and the thermally conductive sheet was pressed at 87 °C and 0.5 MPa for 3 minutes.

### Example 6

In Example 6, as shown in Table 1, a silicone composition was prepared by mixing two-component addition reaction-type liquid silicone with 36% by volume of mixed alumina particles having average particle diameters of 1 µm and 5 µm which were subjected to coupling treatment with a silane coupling agent and 14% by volume of pitch-based carbon fibers having an average fiber length of 200 µm. As the two-component addition reaction-type liquid silicone resin, a two-component addition reaction-type liquid silicone resin mainly composed of an organopolysiloxane was used and the blending ratio of the silicone A agent to the silicone B agent was 53:47. In Example 6, the total amount of the binder resin is 50% by volume, the blending amount of the carbon fiber is 14% by volume, and the volume ratio of the carbon fiber to the binder resin is 0.28.

The obtained silicone composition was extruded into a hollow quadrangular prism-shaped mold (50 mm x 50 mm) to form a silicone molded body with a cross-section of 50 mm square. The silicone molded body was heated in an oven at 100 °C for 6 hours to obtain a silicone cured product. The silicone cured product was cut with a slicer so as to have a thickness of 3.0 mm to obtain a thermally conductive sheet. Then, the thermally conductive sheet was sandwiched between release-treated PET films and the thermally conductive sheet was pressed at 87 °C and 0.5 MPa for 3 minutes.

### Example 7

In Example 7, as shown in Table 1, a silicone composition was prepared by mixing two-component addition reaction-type liquid silicone with 49% by volume of mixed alumina particles having average particle diameters of 1 µm and 5 µm which were subjected to coupling treatment with a silane coupling agent and 14% by volume of pitch-based carbon fibers having an average fiber length of 200 µm. As the two-component addition reaction-type liquid silicone resin, a two-component addition reaction-type liquid silicone resin mainly composed of an organopolysiloxane was used and the blending ratio of the silicone A agent to the silicone B agent was 53:47. In Example 7, the total amount of the binder resin is 37% by volume, the blending amount of the carbon fiber is 14% by volume, and the volume ratio of the carbon fiber to the binder resin is 0.38.

The obtained silicone composition was extruded into a hollow quadrangular prism-shaped mold (50 mm x 50 mm) to form a silicone molded body with a cross-section of 50 mm square. The silicone molded body was heated in an oven at 100 °C for 6 hours to obtain a silicone cured product. The silicone cured product was cut with a slicer so as to have a thickness of 3.0 mm to obtain a thermally conductive sheet. Then, the thermally conductive sheet was sandwiched between release-treated PET films and the thermally conductive sheet was pressed at 87 °C and 0.5 MPa for 3 minutes.

### Example 8

In Example 8, as shown in Table 1, a silicone composition was prepared by mixing two-component addition reaction-type liquid silicone with 37.2% by volume of mixed alumina particles having average particle diameters of 1 µm and 5 µm which were subjected to coupling treatment with a silane coupling agent and 23% by volume of pitch-based carbon fibers having an average fiber length of 200 µm. As the two-component addition reaction-type liquid silicone resin, a two-component addition reaction-type liquid silicone resin mainly composed of an organopolysiloxane was used and the blending ratio of the silicone A agent to the silicone B agent was 53:47. In Example 8, the total amount of the binder resin is 39.8% by volume, the blending amount of the carbon fiber is 23% by volume, and the volume ratio of the carbon fiber to the binder resin is 0.58.

The obtained silicone composition was extruded into a hollow quadrangular prism-shaped mold (50 mm x 50 mm) to form a silicone molded body with a cross-section of 50 mm square. The silicone molded body was heated in an oven at 100 °C for 6 hours to obtain a silicone cured product. The silicone cured product was cut with a slicer so as to have a thickness of 3.0 mm to obtain a thermally conductive sheet. Then, the thermally conductive sheet was sandwiched between release-treated PET films and the thermally conductive sheet was pressed at 87 °C and 0.5 MPa for 3 minutes.

### Example 9

In Example 9, as shown in Table 1, a silicone composition was prepared by mixing two-component addition reaction-type liquid silicone with 48.2% by volume of mixed alumina particles having average particle diameters of 1 µm and 5 µm which were subjected to coupling treatment with a silane coupling agent and 12% by volume of pitch-based carbon fibers having an average fiber length of 200 µm. As the two-component addition reaction-type liquid silicone resin, a two-component addition reaction-type liquid silicone resin mainly composed of an organopolysiloxane was used and the blending ratio of the silicone A agent to the silicone B agent was 53:47. In Example 9, the total amount of the binder resin is 39.8% by volume, the blending amount of the carbon fiber is 12% by volume, and the volume ratio of the carbon fiber to the binder resin is 0.30.

The obtained silicone composition was extruded into a hollow quadrangular prism-shaped mold (50 mm x 50 mm) to form a silicone molded body with a cross-section of 50 mm square. The silicone molded body was heated in an oven at 100 °C for 6 hours to obtain a silicone cured product. The silicone cured product was cut with a slicer so as to have a thickness of 3.0 mm to obtain a thermally conductive sheet. Then, the thermally conductive sheet was sandwiched between release-treated PET films and the thermally conductive sheet was pressed at 87 °C and 0.5 MPa for 3 minutes.

### Comparative Example 1

In Comparative Example 1, as shown in Table 1, a silicone composition was prepared by mixing two-component addition reaction-type liquid silicone with 42.5% by volume of mixed alumina particles having an average particle diameter of 4 µm which were subjected to coupling treatment with a silane coupling agent and 23% by volume of pitch-based carbon fibers having an average fiber length of 150 µm. As the two-component addition reaction-type liquid silicone resin, a two-component addition reaction-type liquid silicone resin mainly composed of an organopolysiloxane was used and the blending ratio of the silicone A agent to the silicone B agent was 53:47. In Comparative Example 1, the total amount of the binder resin is 34.1 % by volume, the blending amount of the carbon fiber is 23% by volume, and the volume ratio of the carbon fiber to the binder resin is 0.67.

The obtained silicone composition was extruded into a hollow quadrangular prism-shaped mold (50 mm x 50 mm) to form a silicone molded body with a cross-section of 50 mm square. The silicone molded body was heated in an oven at 100 °C for 6 hours to obtain a silicone cured product. The silicone cured product was cut with a slicer so as to have a thickness of 1.0 mm to obtain a thermally conductive sheet. Then, the thermally conductive sheet was sandwiched between release-treated PET films and the thermally conductive sheet was pressed at 87 °C and 0.5 MPa for 3 minutes.

### Comparative Example 2

In Comparative Example 2, the silicone cured product prepared in Comparative Example 1 was cut with a slicer so as to have a thickness of 2.0 mm to obtain a thermally conductive sheet. Then, the thermally conductive sheet was sandwiched between release-treated PET films and the thermally conductive sheet was pressed at 87 °C and 0.5 MPa for 3 minutes. In Comparative Example 2, the total amount of the binder resin is 34.1% by volume, the blending amount of the carbon fiber is 23% by volume, and the volume ratio of the carbon fiber to the binder resin is 0.67.

### Comparative Example 3

In Comparative Example 3, the silicone cured product prepared in Comparative Example 1 was cut with a slicer so as to have a thickness of 3.0 mm to obtain a thermally conductive sheet. Then, the thermally conductive sheet was sandwiched between release-treated PET films and the thermally conductive sheet was pressed at 87 °C and 0.5 MPa for 3 minutes. In Comparative Example 3, the total amount of the binder resin is 34.1% by volume, the blending amount of the carbon fiber is 23% by volume, and the volume ratio of the carbon fiber to the binder resin is 0.67.

### Comparative Example 4

In Comparative Example 4, as shown in Table 1, a silicone composition was prepared by mixing two-component addition reaction-type liquid silicone with 70.6% by volume of aluminum nitride particles having an average particle diameter of 1 µm, 5.2% by volume of aluminum hydroxide particles having an average particle diameter of 5 µm, and 3.3% by volume of alumina particles having an average particle diameter of 4 µm, all of which were subjected to coupling treatment with a silane coupling agent. As the two-component addition reaction-type liquid silicone resin, a two-component addition reaction-type liquid silicone resin mainly composed of an organopolysiloxane was used and the blending ratio of the silicone A agent to the silicone B agent was 58:42.

The obtained silicone composition was sandwiched between release-treated PET and coated with a bar coater so as to have a thickness of 1 mm, and heated at 100 °C for 6 hours in an oven to obtain a thermally conductive sheet.

### Comparative Example 5

In Comparative Example 5, as shown in Table 1, the obtained silicone composition was applied to the same conditions as in Comparative Example 4 except that it was sandwiched between release-treated PET and coated with a bar coater to a thickness of 2 mm.

### Comparative Example 6

In Comparative Example 6, as shown in Table 1, the obtained silicone composition was applied to the same conditions as in Comparative Example 4 except that it was sandwiched between release-treated PET and coated with a bar coater to a thickness of 3 mm.

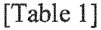

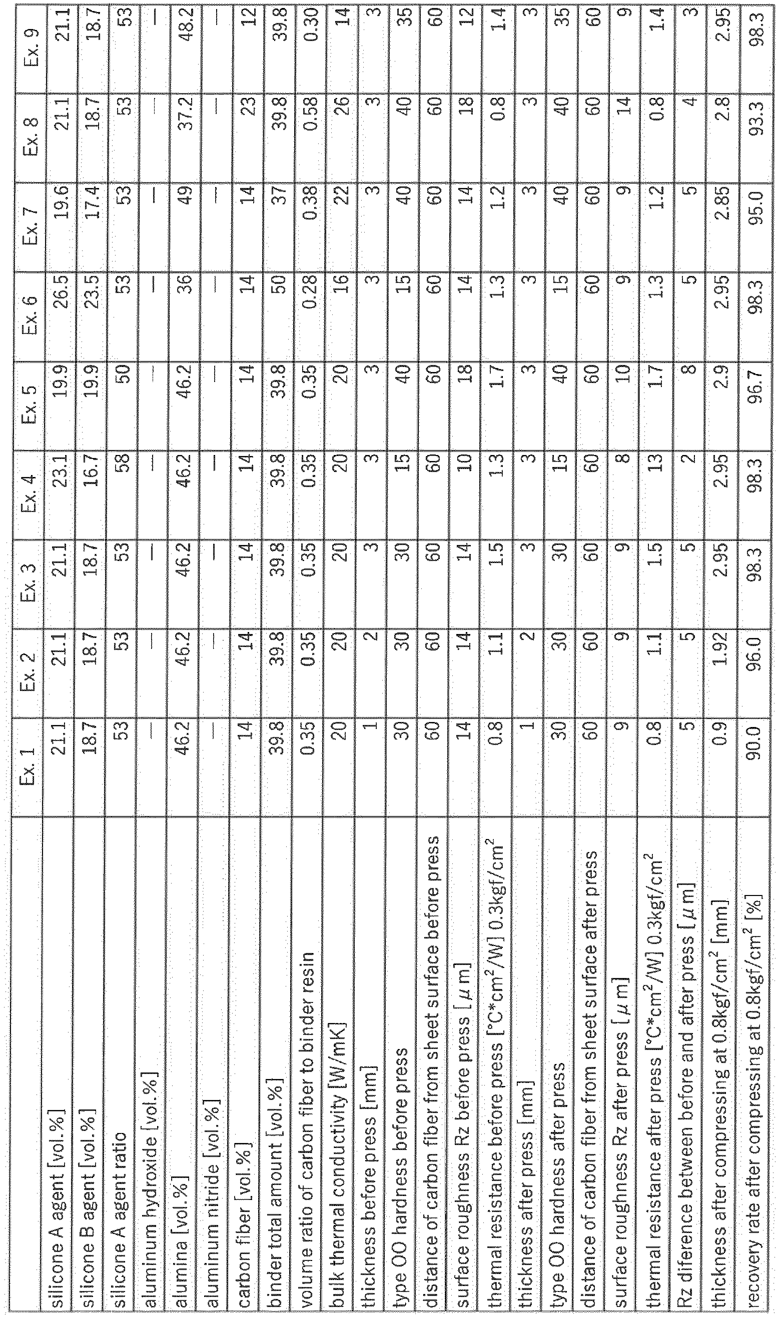

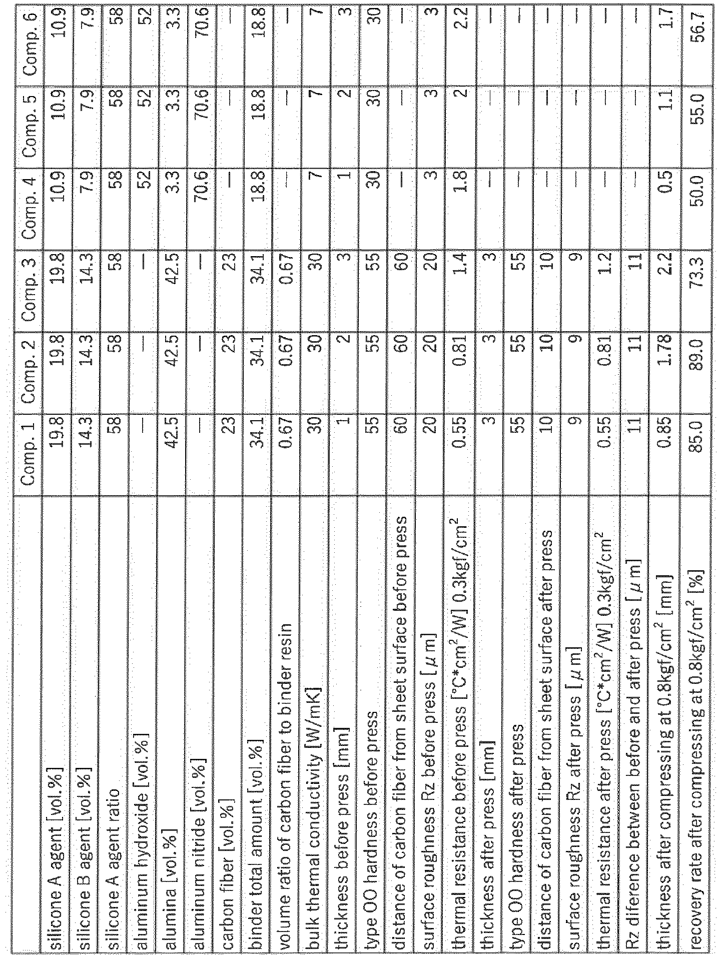

As shown in Table 1, since the volume ratios of the fibrous thermally conductive filler to the binder resin of the thermally conductive sheet according to Examples 1 to 9 are as small as 0.6 or less, the values of type OO in the Durometer hardness standard ASTM-D 2240 are 15 to 40, which are lower than those in Comparative Examples 1 to 3. Further, the Rz value was improved after the pressing, and the recovery rate of the sheet thickness was 90% or more. For this reason, in the thermally conductive sheets according to Examples 1 to 9, the length of projection of the carbon fiber from the sheet surface before and after the pressing is 60 µm, which does not change before and after the pressing. The thermally conductive sheets according to Examples 1 to 9 had a thermal resistance of 1.9 ° C^{∗}cm²/W or less when a load of 0.3 kgf/cm² was applied before and after pressing.

Although the thermally conductive sheets according to Examples 1 to 9 did not have tackiness in the original state, it was confirmed that a tackiness appeared when the sheet was pressed against a glass plate with a finger, and the sheet adhered to the glass plate. Accordingly, it was found that the thermally conductive sheet according to Examples 1 to 9 can reduce or eliminated the tackiness of the sheet surface, have an excellent handleability and workability, exhibit tackiness by pressing, have an excellent adhesiveness to electronic components to reduce thermal resistance, and has reworkability.

On the contrary, in the thermally conductive sheet according to Comparative Examples 1 to 3, the volume ratio of the fibrous thermally conductive filler to the binder resin is larger than 0.6, and the value of the type OO in the Durometer hardness standard ASTM-D 2240 is as high as 55. Although the Rz value was relatively improved after pressing, the recovery rate of the sheet thickness was less than 90%, and the projection length of the carbon fiber from the sheet surface is as short as 10 µm. Therefore, the tackiness remained and the reworkability was inferior.

### DESCRIPTION OF REFERENCE CHARACTERS

1 thermally conductive sheet, 2 sheet body, 10 fibrous thermally conductive filler

## Claims

1. A thermally conductive sheet, comprising:
a sheet body formed by curing a binder resin containing at least a polymer matrix component and a fibrous thermally conductive filler,
wherein the volume ratio of the fibrous thermally conductive filler to the binder resin is 0.6 or less considering the binder resin as 1, and
wherein the fibrous thermally conductive filler projects from the surface of the sheet body and is coated with an uncured component of the binder resin.

2. The thermally conductive sheet according to claim 1, wherein the thermally conductive filler has a projecting length longer than 50 µm from the surface of the sheet body.

3. The thermally conductive sheet according to claim 1, wherein the thermally conductive filler is oriented in the thickness direction of the sheet body.

4. The thermally conductive sheet according to any one of claims 1 to 3, wherein the value of type OO in the durometer hardness standard ASTM-D 2240 is 15 to 40.

5. The thermally conductive sheet according to any one of claims 1 to 3, wherein, after compressing the sheet body with a load of 0.8 kgf/cm² and releasing the load, the thickness of the sheet body recovers to 90% or more of the thickness before compression.

6. The thermally conductive sheet according to any one of claims 1 to 3, wherein, after applying a load to compress the sheet body and releasing the load, the difference in surface roughness Rz of the sheet body before and after the application of the load is 8 or less.

7. The thermally conductive sheet according to any one of claims 1 to 3, wherein, when a load of 0.3 kgf/cm² is applied, the thermal resistance is 1.9° C^{∗}cm²/W or less.

8. A method for manufacturing a thermally conductive sheet, comprising:
a step of forming a thermally conductive molded body by molding and curing a thermally conductive resin composition containing a fibrous thermally conductive filler in a binder resin into a predetermined shape; and
a step of slicing the thermally conductive molded body into a sheet shape to form a thermally conductive sheet,
wherein the volume ratio of the fibrous thermally conductive filler to the binder resin is 0.6 or less considering the binder resin as 1, and
wherein the fibrous thermally conductive filler projects from the surface of the sheet body and is coated with an uncured component of the binder resin.

9. The method according to claim 8, wherein the uncured component of the binder resin is exuded by pressing the thermally conductive sheet.

10. A method for mounting a thermally conductive sheet to be mounted on an electronic component and sandwiched between the electronic component and a heat dissipating member, comprising:
a step of applying a load to the thermally conductive sheet to generate a tackiness when the thermally conductive sheet is mounted on the electronic component, thereby pasting the thermally conductive sheet to the electronic component, and
when the thermally conductive sheet is repasted, the load is released, the thermally conductive sheet is separated from the electronic component, and the thermally conductive sheet is repasted onto the electronic component,
wherein the thermally conductive sheet comprises:
a sheet body formed by curing a binder resin containing at least a polymer matrix component and a fibrous thermally conductive filler,
wherein the volume ratio of the fibrous thermally conductive filler to the binder resin is 0.6 or less considering the binder resin as 1, and
wherein the fibrous thermally conductive filler projects from the surface of the sheet body and is coated with an uncured component of the binder resin.
